# EUROPEAN PATENT APPLICATION

(11) **EP 2 107 381 A2**
(43) Date of publication of application: **07.10.2009**
(21) Application number: 09156230.6
(22) Date of filing: 25.03.2009
(51) Int. Cl.: G01R 19/04, G01R 15/18

(54) **System and method for monitoring current in a conductor**

(30) Priority: 01.04.2008 US 60442
(71) Applicant: General Electric Company, Schenectady, NY 12345 (US)
(72) Inventor: West, Stephen James, Louisville KY Kentucky 40220 (US); Vicente, Nataniel Barbosa, Prospect KY Kentucky 40059 (US); Lenhart, Brian Patrick, Louisville KY Kentucky 40291 (US); Greenwood, Todd, Pewee Valley KY Kentucky 40056 (US); Hameed, Zubair, Louisville KY Kentucky 40241 (US); Devarapalli, Sreenivasulu, Louisville KY Kentucky 40225 (US)
(74) Representative: Illingworth-Law, William Illingworth

(57) **Abstract**

The present disclosure describes a system for measuring current amplitude in a conductor, comprising at least one Rogowski coil (104), an integration circuit (106) directly connected to the at least one Rogowski coil, a microprocessor circuit (114) in communication with the integration circuit and configured to receive output from the integration circuit and to calculate energy data comprising current amplitude in the conductor. A method for measuring current in a conductor is also presented.

## Description

### BACKGROUND

The present invention relates to a system, apparatus and method for monitoring energy data. More specifically, the invention relates to monitoring electrical current amplitude.

Rogowski coils are useful for measuring electrical currents flowing through a conductor. The Rogowski coil provides a voltage output that is proportional to the time derivative of the current (di/dt), rather than a current output like traditional current transformers. One particular advantage of a Rogowski coil is that it does not suffer from voltage saturation and is therefore useful over a wide current range.

One known approach to making a Rogowski coil involves using a printed circuit. For example, U.S. Pat. No. 5,414,400 describes a Rogowski coil implemented on a printed circuit plate provided with a circular cut-out. The coil is implemented by metal deposits on each of the two faces of the plate extending along radii, with electrical connections between the radii on one face and those on the opposite face being achieved via plated-through holes passing through the thickness of the plate. However, this disclosure fails to provide adequate means for external noise cancellation.

One attempt to design Rogowski coils that include improved noise cancellation is described in U.S. Pat. No. 6,624,624. The disclosure describes a current sensor for measuring a time-varying electrical current (Iₘ) in a portion of primary conductor... such that the voltage induced by a magnetic interference field component (Hₛ) orthogonal to the median plane in the clockwise interference field circulating portions is substantially cancelled by the voltage induced in the anti-clockwise interference field circulating portions. However, this circuitry results in significantly reduced coil densities, making the design less appropriate for low frequency (at about 50/60 Hz) current measurement applications. In addition, although improved, all reported geometries suffer from Z-axis (board thickness) related sensitivity effects with an error path normally offset in the direction of the Z-axis (board thickness).

US Patent 7,227,442 discloses a printed circuit board based Rogowski coil that is formed with an aperture for receiving an electrical path therethrough. While this patent describes a resistive network for cancellation of external magnetic fields, it describes the placement of multiple Rogowski coils along a conductor, leading to a more complex motherboard.

Accordingly, there is a need for a relatively simple and noise-free circuit for use with Rogowski coils.

### BRIEF DESCRIPTION

The present disclosure describes a system for measuring current amplitude in a conductor, comprising at least one Rogowski coil, an integration circuit directly connected to the at least one Rogowski coil, a microprocessor circuit in communication with the integration circuit and configured to receive output from the integration circuit and to calculate energy data comprising current amplitude in the conductor.

In another embodiment of the present invention, the invention provides a method for monitoring current comprising gathering current data from a first conductor via a Rogowski coil, providing a integration circuit directly connected to the Rogowski coil, transmitting current data from the integration circuit to a main circuit board via serial, parallel or wireless communication and processing the data to provide a current reading.

Other features and advantages of the disclosure will become apparent by reference to the following description taken in connection with the accompanying drawings.

### BRIEF DESCRIPTION OF THE DRAWINGS

Reference is now made briefly to the accompanying drawings, in which:
Figure 1 is block diagram of current monitoring system.
Figure 2 is a schematic diagram of electrical circuitry in accordance with embodiments of the present invention.
Figure 3 is a flow chart describing a step-wise method in accordance with a further embodiment of the present invention.

Like reference characters designate identical or corresponding components and units throughout the several views, which are not to scale unless otherwise indicated.

### DETAILED DESCRIPTION

An embodiment of the present invention involves a current monitoring system which comprises at least one Rogowski coil and a metering/integration circuit attached to the Rogowski coil which outputs current amplitude data for input to a processor. One particular advantage afforded by this invention is increased noise reduction and decreased signal degradation in Rogowski coil circuitry.

Specific configurations and arrangements of the claimed invention, discussed below with reference to the accompanying drawings, are for illustrative purposes only. Other configurations and arrangements that are within the purview of a skilled artisan can be made, used, or sold without departing from the spirit and scope of the appended claims. For example, while some embodiments of the invention are herein described with reference to a commercial plant site, a skilled artisan will recognize that embodiments of the invention can be implemented in any setting in which remote energy data monitoring is advantageous.

As used herein, an element or function recited in the singular and proceeded with the word "a" or "an" should be understood as not excluding plural said elements or functions, unless such exclusion is explicitly recited. Furthermore, references to "one embodiment" of the claimed invention should not be interpreted as excluding the existence of additional embodiments that also incorporate the recited features.

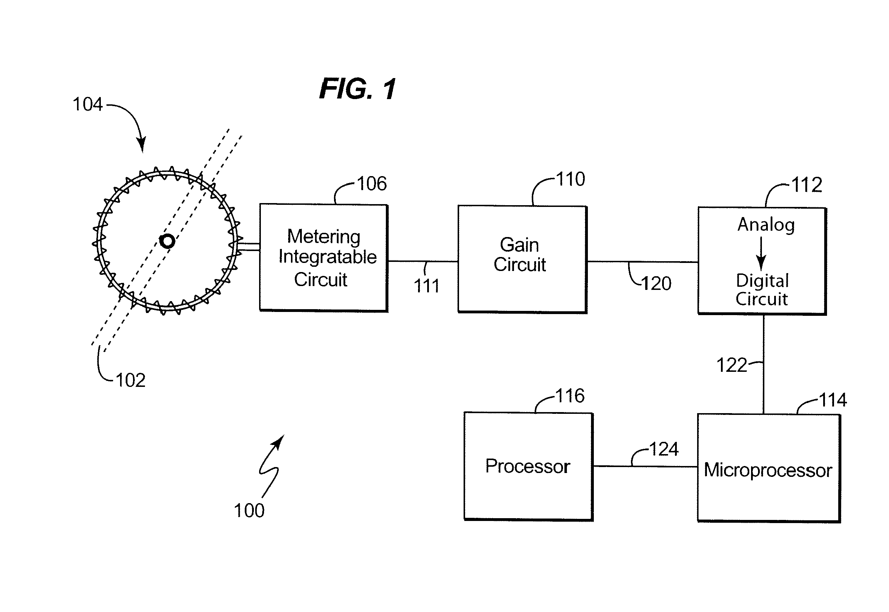

Referring now to Figure 1, a block diagram of an exemplary system for monitoring current in a conductor is shown generally at 100. The system 100 is provided for monitoring current level flowing through a conductor 102 and may comprise at least one Rogowski coil 104, metering/integration circuitry 106, and a processor 116.

The Rogowski coil 104 may be looped around a conductor 102. In one embodiment of the present invention the conductor may comprise, three-phase wiring, bus bars, or other wiring that works in conjunction with tip units or circuit breakers. It is advantageous to use a Rogowski coil in embodiments of the present invention for current measurement because unlike current transformers the two ends of the Rogowski coil may be separated and fit around a large bus bar. Furthermore, where the Rogowski coil comprises an air core, as opposed to a ferromagnetic substance as in current transformers, there is no true core to saturate.

The Rogowski coil 104 may comprise two wire loops, with both loops having wire wound in electrically opposing directions thereby substantially reducing electrical fields coming from outside each loop. Also, it is to be appreciated that the Rogowski coil may be designed having a flexible core, such as a coaxial cable or, in high performance applications, the core may comprise steel rod(s). Generally, a voltage, from the conductor 102 will be induced in the Rogowski coil that is proportional to the rate of change in time of current flowing through the conductor 102. By integrating the output of the Rogowski coil 104 as a function of time (dᵢ/dₜ), current amplitude is provided.

With further reference to Figure 1, metering and integration circuit (hereinafter "integration circuit") 106 may be directly connected to the Rogowski coil 104. The term "directly connected" as used herein shall be understood to mean connected in a manner that avoids any intervening electrical/electronic components and/or electrical lead portions of greater than approximately 0.250 inches (6.35 millimeters).

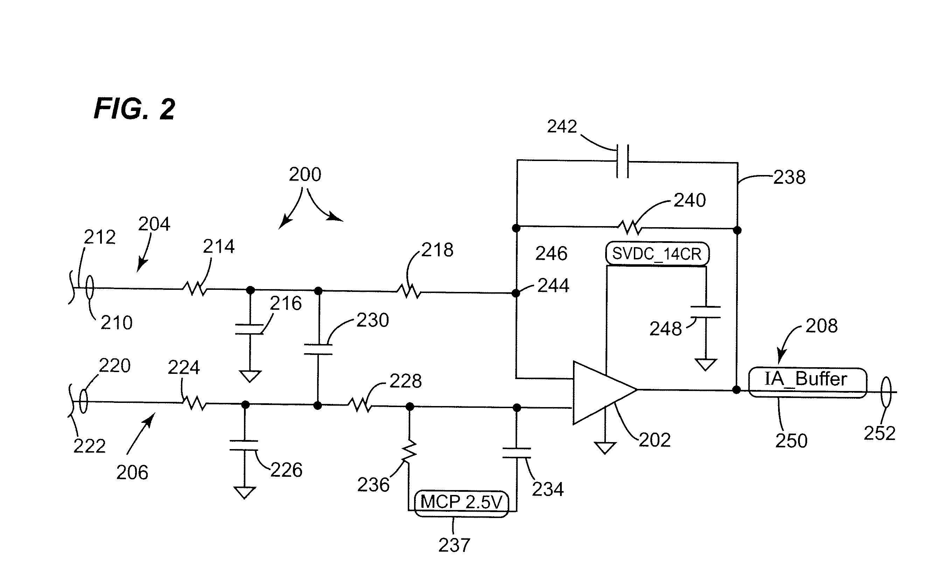

The Rogowski coil 104 may be electrically connected with the integration circuit 106 via lines 128, which will be discussed in greater detail with reference to Figure 2. The integration circuit 106 may be configured to perform an integration step to convert the voltage output from the Rogowski coil 104 to current amplitude. The integration circuit 106 may comprise appropriately configured hardware or software and may further communicate with gain circuitry 110.

Gain circuitry 110 may be electrically connected to integration circuit 106 via line 118. In an exemplary embodiment of the present invention, the gain circuitry may be configured to amplify the current amplitude from the integration circuit. For example, a gain circuit usable in embodiments of the present invention may include any hardware derating for multiple different Rogowski coils, any offset/calibration using the microcontroller, or any window/gain operations to zoom in for maximum A/D resolution by minimizing the range window.

Analog to digital converter circuitry 112 may be electrically connected to the gain circuitry via line 120. In this exemplary embodiment, analog to digital conversion circuitry 120 may be configured to convert the amplified input analog current amplitude from gain circuit 110 into a digital current amplitude data via number scheme such as binary code, Gray's code or two's binary code. The conversion from an analog signal to a digital signal (e.g., serial or parallel communication) may greatly reduce the inherent noise induced into the system. However, it is to be appreciated that while a digital signal may be most advantageous for avoiding noise problems associated with prior art circuits and thereby acquiring an accurate current reading, a suitably amplified analog signal may be used as well. Furthermore, while a linear response-type analog to digital converters may most advantageous in the present invention, it is to be appreciated that a nonlinear response-type analog to digital converter may be used in applications where the probability density function of the signal being digitized is uniform.

The analog to digital converter is further electronically coupled to microprocessor 114. Microprocessor 114 may comprise a microcontroller which may further comprise read-write memory for temporary data storage, or read-only memory or EEPROM for permanent data storage. The use of a microcontroller may be favorable in cost-effective applications because of their low power draw (e.g., in the order milliwatts). However, in high-speed applications, it may be advantageous to use an ARM/DSP Processor, as they have much higher throughput. The microprocessor 114 may be configured to take the current amplitude information and record waveform data (e.g., during fault conditions), or calculate energy data which may comprise the current amplitude and/or power consumption. Furthermore, the processor may provide configuration of MCR and/or High Set Hardware thresholds (i.e., peak detectors in hardware circuitry).

In one particular embodiment of the present invention, the microprocessor 114 is configured to send the calculated energy data to the processor 116 via line 124 when poled by the processor. Optionally, the microprocessor 114 may be configured to send the energy data information to the processor 116 continuously or in predetermined regular intervals. Line 124 may comprise a single pair wire for serial communication or a cable for parallel communication.

The processor 116 may be configured to gather and manage the energy data received from microprocessor 114. The processor 116 may be further configured to automatically perform general optioning steps to match circuit breaker requirements. This eliminates the optioning that generally occurs at the factory (i.e., matching Rogowski coil requirements with circuit board and circuit breaker requirements depending upon a myriad of applications). This, in turn, obviates the need to redesign the main processor when multiple Rogowski coils are added to a system already in place. Furthermore, because integration is occurring at the Rogowski coil 104 via integration circuit 106, external noise and measurement corruption are severely limited. This gives operators the ability to place the processor 116 and decision making aspects of the system farther away from the where the measurement is taking place, thereby obviating the need for further noise reducing steps, e.g., resistive networks

In another embodiment of the present invention, the processor 116 may be electrically connected to a circuit breaker assembly 126 via line 128. The breaker assembly may comprise a flux shifter (not shown) which may be further communication with the processor 116. In turn, the processor 116 may be configured to close the flux shifter when a trip time is exceeded.

In an optional embodiment of the present invention, the system may further comprise fault detection such as one or more Make Contact Release (MCR) circuits, as described below, and a circuit breaker 126. The MCR circuit may be configured to power into a fault position if current levels reach a predetermined level (e.g., logic high).

Referring now to Figure 2 an exemplary embodiment of an integration circuit usable in the practice of the present invention is shown generally at 200. The integration circuit 200 comprises a differential amplifier 202 in circuit with a first input leg 204, a second input leg 206 and an output leg 208.

The first input leg 204 comprises a terminal 210 serially connected with a winding 212 of a Rogowski coil and a resistor 214. A high pass capacitor 216 is provided for filtering purposes along with another resistor 218.

The second input leg 206 comprises a terminal 220 serially connected with a second winding 222 of the Rogowski coil and a resistor 214. A high pass capacitor 226 is also provided for filtering purposes along with a further resistor 228. A capacitor 230 interconnects the first and second input legs 230 to cancel residual noise.

A smoothing circuit 232 is connected in parallel with the second input leg 206 and comprises a capacitor 234 and resistor 236 separated by a first MCR circuit 237. The smoothing circuit 232 also is configured so that the differential amplifier 202 will be referenced to 2.5 volts.

The output leg 208 comprises a feedback circuit 238 that, in turn, comprises a parallel arrangement of a resister 240 and capacitor 242. The feedback circuit 238 is connected to the first input leg 204 at a node 244.

The differential amplifier may be energized by a power circuit 246 comprising an MCR circuit that is in series with a capacitor 248. The output of the differential amplifier may be passed to a buffer 250 and onto a terminal 252.

In another embodiment of the present invention, the invention provides a method for monitoring current comprising gathering current data from a first conductor via a Rogowski coil, providing a integration circuit directly connected to the Rogowski coil, transmitting current data from the integration circuit to a processor and processing the data to provide a current reading.

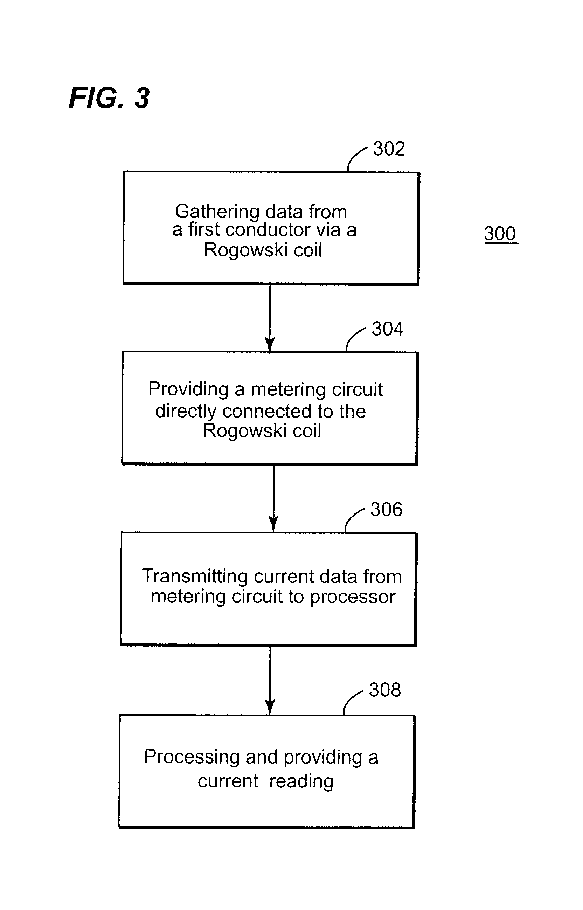

With reference now to Figure 3, there is shown a flow chart to better help illustrate a method for monitoring energy data generally at 300. While the flowchart shows an exemplary step-by-step method, it is to be appreciated that a skilled artisan may rearrange or reorder the steps while maintaining like results.

Gathering data from a first conductor via a Rogowski coil 302 may comprise utilization of a plurality of Rogowski coils placed at various places along a conductors path. The conductor may comprise, for example, typical three phase electrical power system, or large bus bars used in high voltage applications.

Providing an integration circuit directly connected to the integration circuit is shown at 304 and which may serve at least two purposes. Because Rogowski coils do not measure current levels directly, but rather gather voltage data, which is proportional to the rate of chance in time of the current in the conductor, an integration (di/dt) must be performed to find current. Therefore, a metering/integration circuit may be provided to perform calculations necessary to provide an output of current. Furthermore, attaching an integration circuit directly to the Rogowski coil may greatly reduce inherent noise in the system, as Rogowski coils have a limitation of spacing from the measurement (i.e., if there is too much wire from the processor to the Rogowski coils, significant amounts of signal degradation and noise may occur, thereby obscuring the output reading). Therefore, attaching the integration circuit directly to the Rogowski coil may eliminate much of the output degradation and noise in the system.

Transmitting the current data from integration circuit to the processor, shown at 306, may occur via analog or digital (parallel or serial protocols) communication. In some embodiments or the present invention, intermediary steps may be performed during data transmission. For example, the metering/integration circuit may be electrically connected to gain circuitry to amplify the signal if advantageous to performance and accuracy. Also, if digital communication is required, the invention may utilize analog to digital converter circuitry. Furthermore, this step may include the addition of a microcontroller or a microprocessor configured for read-write memory for data storage, read-only memory, EEPROM for permanent data storage, or FLASH/memory located on the MCU or equivalent processor.

Processing the data and providing a current reading 308 may comprise a processor configured for gathering, storing and metering purposes. The processor may perform a full cycle or half cycle integration (true RMS), a peak detection, SSO (sum of squares) operations, capture high peaks/waveform data after a fault has occurred, record errors of any sort with communication, perform gain setting, recognize MCR/HSET failures and communicate with the central trip unit of the breaker. Furthermore, the processor may be configured to automatically perform general optioning steps to match circuit breaker requirements. This eliminates the optioning that generally occurs at the factory (e.g., matching Rogowski coil requirements with circuit board and circuit breaker requirements depending upon a myriad of applications). This, in turn, obviates the need to redesign the main processor when multiple Rogowski coils are added to a system already in place.

Although specific features of various embodiments of the invention may be shown in some drawings and not in others, this is for convenience only. In accordance with the principles of the invention, the feature(s) of one drawing may be combined with any or all of the features in any of the other drawings. The words "including", "comprising", "having", and "with" as used herein are to be interpreted broadly and comprehensively and are not limited to any physical interconnection. Moreover, any embodiments disclosed herein are not to be interpreted as the only possible embodiments. Rather, modifications and other embodiments are intended to be included within the scope of the appended claims.

## Claims

1. A system for measuring current amplitude in a conductor, comprising:
at least one Rogowski coil;
an integration circuit directly connected to the at least one Rogowski coil; and
a microprocessor circuit in communication with the integration circuit and configured to receive output from the integration circuit and to calculate energy data comprising current amplitude in the conductor.

2. The system of claim 1, further comprising gain circuitry electrically connected to the integration circuit and configured to amplify a output received therefrom.

3. The system of claim 1 or claim 2, further comprising an analog to digital converter circuit electrically connected to the gain circuitry.

4. The system of any one of the preceding claims, further comprising a processor configured to communicate with the microprocessor and to communicate the energy data to a main control unit and wherein the processor is also configured to identify an aspect of the at least one Rogowski coil and whereby it may configure itself to match the energy data calculations based on the at least one Rogowski coil.

5. The system of any one of the preceding claims, wherein the conductor comprises three-phase electrical wiring.

6. The system of claim 4, wherein the processor is configured to communicate with a flux shifter, wherein the processor is further configured to close the flux shifter when a trip time is exceeded.

7. The system of any one of the preceding claims, further comprising an Make Contact Release electrically connected to a breaker and configured to power the breaker into a fault condition if a current level is outside a predetermined range.

8. A method for monitoring current in a conductor comprising:
gathering current data from a first conductor via a Rogowski coil;
providing a integration circuit directly connected to the Rogowski coil;
transmitting current data from the integration circuit to a main circuit board via serial, parallel or wireless communication; and
processing the data to provide a current reading.

9. The method of claim 8, further comprising analog to digital conversion circuitry electrically connected to the gain circuitry and configured to convert an amplified signal from analog to digital communication.

10. The method of claim 8 or claim 9, wherein the transmitting step further comprising a microcontroller.

11. The method of any one of claims 8 to 10, wherein the processing step further comprises identifying an aspect of the at least one Rogowski coil and whereby it may configure itself to match the at least one Rogowski coil.

12. The method of any one of claims 8 to 11, wherein the conductor comprises three-phase electrical wiring.

13. The method of claim 8, wherein the integration circuit is configured to integrate voltage data obtained from the Rogowski as a function of time to calculate current data.

14. The method of any one of claims 8 to 13, wherein the processor is configured to perform sum of squares operations, half and full cycle sun of squares operations, peak detection, error detection, half and full cycle sliding SSO, and communicate with main control unit.

15. The method of any one of claims 8 to 14, further comprising an MCR electrically connected to a breaker and configured to power the breaker into a fault condition if a current level is outside a predetermined range.
